# EUROPÄISCHE PATENTSCHRIFT

(11) **EP 1 835 523 B1**
(45) Veröffentlichungstag und Bekanntmachung des Hinweises auf die Patenterteilung: **29.06.2016**
(21) Anmeldenummer: 07102803.9
(22) Anmeldetag: 21.02.2007
(51) Int. Cl.: G01N 23/04, H01J 37/04, H01J 37/26

(54) **Phasenkontrast-Elektronenmikroskop**
Phase-contrast electron microscope
Microscope à électrons à contraste de phase

(30) Priorität: 14.03.2006 DE 102006011615
(43) Veröffentlichungstag der Anmeldung: 19.09.2007
(73) Patentinhaber: Carl Zeiss NTS GmbH, 73447 Oberkochen (DE)
(72) Erfinder: Benner, Gerd, 73434, Aalen (DE); Matijevic, Marko, 72622, Nürtingen (DE)
(74) Vertreter: Gnatzig, Klaus

(56) Entgegenhaltungen:
- EP-A- 1 329 936
- WO-A-2005/022582
- US-A- 2 802 110
- US-A1- 2002 148 962

## Beschreibung

Die vorliegende Erfindung betrifft ein Phasenkontrast-Elektronenmikroskop und insbesondere ein Phasenkontrast-Transmissions-Elektronenmikroskop (Phasenkontrast TEM).

Elektronenmikroskopische Präparate sind in der Regel Phasenobjekte, die aufgrund der hohen Elektronenenergie im Bereich 100 keV und größer nur einen sehr geringen Amplitudenkontrast in einem Transmissions-Elektronenmikroskop (TEM) erzeugen. Deshalb erzeugen derartige Objekte in einem gewöhnlichen TEM nur unter Ausnutzung der phasenschiebenden Wirkung des Öffnungsfehlers des TEM einen Kontrast und werden deshalb in einem gewöhnlichen TEM entsprechend kontrastarm abgebildet. Das Einbringen einer Phasenplatte in die hintere Brennebene des Objektivs des TEM bringt daher - anlog zur Erzeugung eines Phasenkontrasts bei Phasenobjekten nach Zernicke in der Lichtmikroskopie - grundsätzlich einen großen Kontrastgewinn. Problematisch sind dabei allerdings die bei einem TEM erforderlichen Dimensionen; insbesondere wenn der sogenannte Nullstrahl, also nur die am Präparat ungebeugte Strahlung, phasenverschoben werden soll, hingegen jedoch die am Präparat in die erste Ordnung oder höhere Ordnungen gebeugte Strahlung von der Phasenplatte unbeeinflusst bleiben soll, stellt der kleine Durchmesser des Nullstrahls von kleiner 1 µm erhebliche Anforderungen an die Technologie, da für die Phasenplatte Kontaminationsfreiheit, Aufladungsfreiheit und Durchschlagsfestigkeit zu fordern sind.

Zur Erzeugung der phasenschiebenden Wirkung sind im Grunde zwei Ansätze bekannt: Beim ersten Ansatz ist die Phasenplatte als eine entsprechend klein ausgebildete elektrostatische Linse realisiert, die nur dem Nullstrahl eine Phasenverschiebung aufprägt, aber die höheren Beugungsordnungen ganz oder weitgehend unbeeinflusst lässt. Beim zweiten Ansatz wird eine dünne, für Elektronen der im TEM verwendeten Elektronenenergie weitgehend transparente Folie eingesetzt, die die erforderliche Struktur aufweist. Beim zweiten Ansatz werden die inneren elektrostatischen Potenziale des Materials ausgenutzt, um dem gestreuten Elektronenstrahl oder dem Nullstrahl die gewünschte Phasenverschiebung aufzuprägen. Der erste Ansatz hat dabei den Nachteil, dass die kleine elektrostatische Linse zwangsweise äußere Hälterungsstrukturen erfordert, die Bereiche, in denen die Bahnen der in höhere Beugungsordnungen gebeugten Elektronen verlaufen, unterbrechen, wodurch für die Bilderzeugung wichtige Information verloren geht. Der zweite Ansatz hat dem gegenüber den Nachteil, dass die gegenüber dem Nullstrahl ohnehin schon sehr schwachen höheren Beugungsordnungen durch die unvermeidbare Materialabsorption der Folie zusätzlich geschwächt werden. Aufgrund dieser technologischen Probleme konnten bisher noch keine Phasenkontrast-Elektronenmikroskope mit phasenschiebenden Elementen als kommerzielle Produkte erfolgreich auf dem Markt etabliert werden, obwohl die Grundlagen für die Erzeugung von Phasenkontrast seit mehr als 50 Jahren bekannt sind.

Phasenkontrast-Elektronenmikroskope sind bereits in der US 6,744,048 B2, der US 6,797,956 beschrieben.

In der US 6,744,048 wurde bereits vorgeschlagen, durch ein Linsensystem die hintere Brennebene des Objektivs abzubilden und das phasenschiebende Element in der vom Linsensystem erzeugten Bildebene der Beugungsebene des Objektivs anzuordnen.

Es ist ein erstes Ziel der vorliegenden Erfindung, ein Phasenkontrast-Elektronenmikroskop anzugeben, bei dem die dimensionsmäßigen Anforderungen an das phasenschiebende Element reduziert sind. Diese Ziel wird mit einem Phasenkontrast-Elektronenmikroskop mit den Merkmalen des Anspruchs 1 erreicht.

Es ist ein weiteres Ziel der Erfindung, bei einem Phasenkontrast-Elektronenmikroskop Informationsverluste zu vermeiden. Dieses Ziel wird durch ein Phasenkontrast-Elektronenmikroskop mit den Merkmalen des Anspruchs 2 gelöst.

Vorteilhafte Ausführungsformen der Erfindung ergeben sich aus den Merkmalen der abhängigen Patentansprüche.

Ein Phasenkontrast-Elektronenmikroskop nach einem ersten Aspekt der Erfindung weist ein Objektiv mit einer hinteren Brennebene und eine erste Beugungslinse auf, die die hintere Brennebene des Objektivs vergrößert in eine Beugungs-Zwischenbildebene abbildet. Der ersten Beugungslinse folgt, in Ausbreitungsrichtung der Elektronen, eine zweite Beugungslinse, deren Hauptebene in der Nähe der Beugungs-Zwischenbildebene angeordnet ist. In oder in der Nähe der Beugungs-Zwischenbildebene ist ein phasenschiebendes Element angeordnet.

Bei einem Phasenkontrast-Elektronenmikroskop nach dem zweiten Aspekt der Erfindung ist das phasenschiebende Element in der Beugungs-Zwischenbildebene ein zweites phasenschiebendes Element und es ist zusätzlich in der hinteren Brennebene des Objektivs ein erstes phasenschiebendes Element angeordnet. Die mit der ersten Beugungslinse bewirkte Abbildung der hinteren Brennebene in die Beugungs-Zwischenbildebene ist dabei vergrößernd.

Dadurch, dass die Beugungsebene des Objektivs vergrößert in eine Beugungs-Zwischenbildebene abgebildet wird, kann das phasenschiebende Element entsprechend geometrisch vergrößert ausgebildet sein, so dass die dimensionsmäßigen Anforderungen an das phasenschiebende Element entsprechend reduziert sind. Gleichzeitig wird die Ausblendung von Elektronen durch die Hardware der Phasenplatte, insbesondere Elektroden und Haltestege, reduziert, da die Dimensionen dieser Teile gleich bleiben können. Außerdem kann gleichzeitig gewährleistet werden, dass durch die Aberration der zusätzlichen Beugungslinsen keine Auflösungsverschlechterung auftritt und das Bild der Beugungsebene hinter dem System der Beugungslinsen wieder deutlich hinter den Bildebenen liegt, die zu der Gegenstandsebene des Objektivs konjugiert sind.

Dadurch dass gemäß dem ersten Aspekt der Erfindung die Hauptebene der zweiten Beugungslinse in oder in der Nähe der Beugungs-Zwischenbildebene liegt, hat diese fast ausschließlich Einfluss auf die Lage der zur Gegenstandsebene des Objektivs konjugierten Bildebene und nahezu keinen Einfluss auf die weitere Abbildung der Beugungs-Zwischenbildebene. Die erforderliche Baulängenvergrößerung kann dadurch gering gehalten werden.

Weitere Einzetheiten der Erfindung werden nachfolgend anhand der in den Figuren dargestellten Ausführungsbeispiele näher erläutert. Dabei zeigen:
- Figur 1:: Die Prinzipskizze eines Phasenkontrast-Transmissions-Elektronenmikroskops im Schnitt;
- Figur 2:: die Strahlverläufe im Elektronenmikroskop nach Figur 1 in einem ernsten Betriebsmodus;

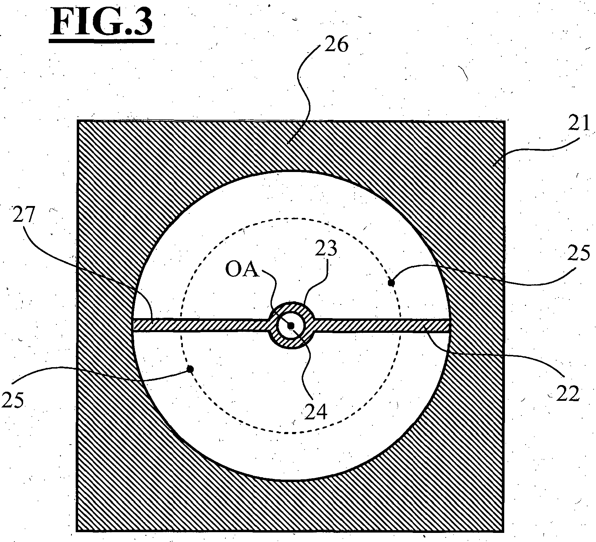

- Figur 3:: die Aufsicht auf eine elektrostatische Phasenplatte in einem Elektronenmikroskop nach Figur 1;
- Figur 4: die Strahlverläufe im Phasenkontrast-Elektronenmikroskop mit einer konischen Beleuchtungsapertur;
- Figur 5:: die Strahlverläufe in einem System mit zwei Phasenplatten, die jeweils in zueinander konjugierten Ebenen angeordnet sind;
- Figur 6:: die Strahlverläufe im Elektronenmikroskop nach Figur 1 in einem zweiten Betriebsmodus; und
- Figur 7:: die Strahlverläufe im Elektronenmikroskop nach Figur 1 beim Betrieb als Lorenz Mikroskop sowie bei geringer Vergrößerung.

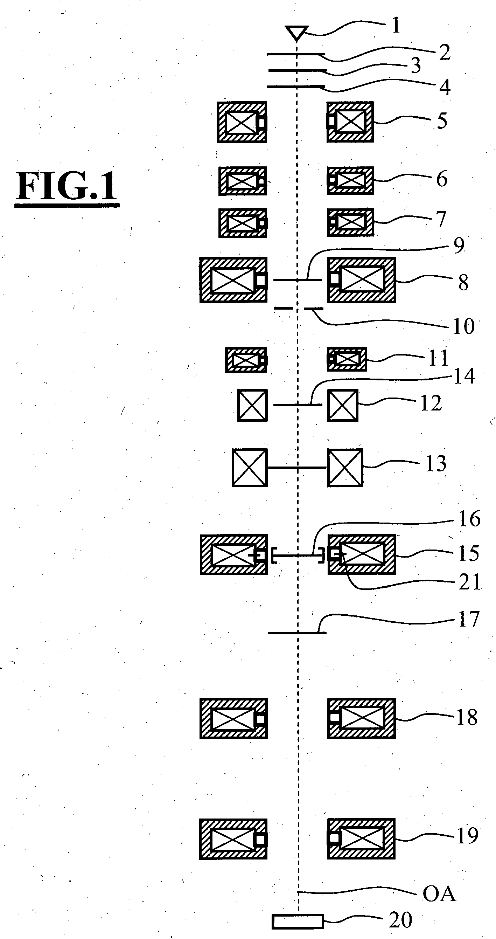

Das Transmissions-Elektronenmikroskop in Figur 1 weist eine Elektronenquelle (1), beispielsweise eine thermische Feldemissionsquelle auf. Auf die Elektronenquelle (1) folgen zunächst eine Extraktionselektrode (2), durch deren Potenzial Elektronen aus der Elektronenquelle (1). herausgesaugt werden, eine oder mehrere Fokussierelektroden (3), um die Quellenlage optisch ortsfest zu halten, und eine oder mehrere Anoden (4). Durch das Potenzial der Anode (4) werden die aus der Elektronenquelle (1) austretenden Elektronen auf die gewünschte Elektronenenergie von 100 keV oder mehr beschleunigt.

Auf die Anode folgt in Bewegungsrichtung der Elektronen ein mehrstufiger Kondensor. Im dargestellten Ausführungsbeispiel weist der Kondensor drei einzelne Magnetlinsen (5, 6, 7) und den eingangseitigen Teil der Kondensor-Objektiv-Einfeldlinse (8) auf. Durch einen derartigen Kondensor ist durch entsprechende Einstellung der Linsenströme der Magnetlinsen (5, 6, 7, 8) sowohl die Beleuchtungsapertur als auch das durch den Elektronenstrahl ausgeleuchtete Feld der in der Hauptebene der Kondensor-Objektiv-Einfeldlinse (8) liegenden Objektebene (9) unabhängig einstellbar. Hinsichtlich der Strahlführung im Kondensor bei unterschiedlich ausgeleuchteten Leuchtfeldern und Aperturen sei auf die US 5,013,913 verwiesen, so dass darauf an dieser Stelle nicht näher eingegangen zu werden braucht. Anstelle eines insgesamt vierstufigen Kondensors kann allerdings auch ein einfacherer Kondensor beispielsweise nach der US 6,531,698 vorgesehen sein.

Von der Kondensor-Objektiv-Einfeldlinse (8) wirkt das Vorfeld als letzte Kondensorlinse und das Nachfeld als Objektivlinse. Die Objektebene liegt etwa in Höhe des Polschuhspalts der Kondensor-Objektiv-Einfellinse (8). In der Objektebene (9) ist der nicht dargestellte Probenmanipulator in Form eines Goniometers angeordnet, der durch den Polschuh der Kondensor-Objektiv-Einfeldlinse (8) hindurch gerührt ist.

Anstelle einer Kondensor-Objektiv-Einfeldlinse kann auch eine anderweitige Objektivlinse vorgesehen sein.

Auf die Kondensor-Objektiv-Einfeldlinse (8) folgt eine erste Beugungslinse (11), die ebenfalls als Magnetlinse ausgebildet ist. Diese erste Beugungslinse (11) bildet die hintere Brennebene bzw. Beugungsebene (10) der Köndensor-Objektiv-Einfeldlinse (8) in eine Beugungs-Zwischenbildebene (21) vergrößert ab. Gleichzeitig erzeugt die erste Beugungslinse (11) ein reelles Zwischenbild (14) der Objektebene (9). In der Ebene des von der ersten Beugungslinse (11) erzeugten Zwischenbilds (14) ist ein erstes Ablenksystem (12) angeordnet. Auf dieses erste Ablenksystem (12) folgt ein zweites Ablenksystem und darauf eine zweite Beugungslinse (15). Die Beugungs-Zwischenbildebene (21) liegt dabei gleichzeitig in oder in der Nähe der Hauptebene der zweiten Beugungslinse (15).

In der Beugungs-Zwischenbildebene (21) ist die Phasenplatte (16) angeordnet. Da das Bild der hinteren Beugungsebene (10) der Objektivlinse oder des als Objektiv wirkenden Nachfelds der Kondensor-Objektiv-Einfeldlinse (8) durch den Abbildungsmaßstab der durch die erste Beugurigslinse (11) erzeugten Abbildung vergrößert ist, kann der Durchmesser der Phasenplatte (16) um diesen Abbildungsmaßstab vergrößert sein gegenüber einer Anordnung der Phasenplatte (16) direkt in der hinteren Brennebene (10) der Objektivlinse. Die anderen Dimensionen der Phasenplatte (16) wie die Breite der Haltestege (22, 27) und die Ringstärke der ringförmigen Elektrode können dagegen gleich dimensioniert bleiben, so dass die Ausblendung von Elektronen durch diese Komponenten insgesamt reduziert ist.

Die Vergrößerung, mit der die Beugungsebene (21) in die Beugungs-Zwischenbildebene abgebildet wird, sollte größer als zweifach, vorzugsweise größer als dreifach sein. Die Vergrößerung, mit der die Beugungsebene (21) in die Beugungs-Zwischenbildebene abgebildet wird, sollte eine 10-fache Vergrößerung nicht überschreiten und vorzugsweise zwischen dreifacher Vergrößerung und siebenfacher Vergrößerung betragen.

Da die zweite Beugungslinse (15) so angeordnet ist, dass ihre Hauptebene in oder in der Nähe der Beugungs-Zwischenbildebene liegt, hat die zweite Beugungslinse (15) keinen oder keinen nennenswerten Einfluss auf die weitere Abbildung der Beugungs-Zwischenbildebene (21). Diese zweite Beugungslinse (15) bildet in erster Linie das Zwischenbild (14) der Objektebene (9) in die Eingangsbildebene (17) des Projektivsystems (18, 19) ab. Dadurch kann ein geeignet großer Abstand der nachfolgenden Bildebenen der Objektebene (9) und Beugungsebene (10) gewährleistet werden. Das Projektivsystem (18, 19) erzeugt dann von der in der Objektebene (9) angeordneten und in die Eingangsbildebene (17) des Projektivsystems (18, 19) abgebildeten Probe ein stark vergrößertes Bild auf einem Detektor (20).

Mit (OA) ist in der Figur 1 die optische Achse des gesamten elektronenoptischen Systems bezeichnet.

Mithilfe der Ablenksysteme (12, 13) zwischen der ersten Beugungslinse (11) und der zweiten Beugungslinse (15) kann die laterale Lage des Bilds der hinteren Beugungsebene (10) des Objektivs relativ zur Phasenplatte (16) fein justiert werden. Da das erste Ablenksystem in der Ebene angeordnet ist oder wirkt, in der das Zwischenbild (14) der Objektebene entsteht, hat eine durch dieses erste Ablenksystem bewirkte Ablenkung keinerlei Einfluss auf die laterale Lage des in der Eingangsbildebene (17) des Projektivsystems entstehenden Bilds der Objektebene (9), sondern schiebt nur die Lage des Beugungsbilds relativ zur Phasenplatte (16).

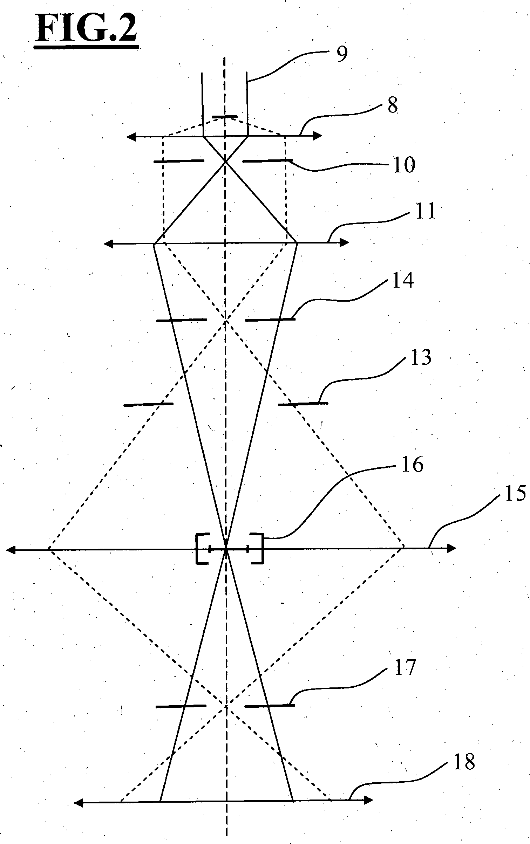

Die zuvor beschriebenen Abbildungseigenschaften zwischen der Objektivlinse (8) und der ersten Projektivlinse (18) sind in der Figur 2 anhand der Strahlverläufe anschaulich dargestellt. Dabei sind mit durchgezogenen Linien die Strahlverläufe für Elektronen, die parallel zur optischen Achse (OA) aus der Objektebene (9) austreten - der so genannte Beleuchtungs- oder Pupillenstrahlengang -, und gestrichelt die Strahlverläufe für Elektronen, die auf der optischen Achse (OA) unter einem Winkel zur optischen Achse (OA) aus der Objektebene (9) austreten - der so genannte Abbildungsstrahlengang -, gezeichnet.

In der Figur (3) ist eine elektrostatische Phasenplatte (16) in Aufsicht dargestellt. Die Phasenplatte (16) hat einen äußeren für Elektronen undurchlässigen Träger (21) mit einem runden Loch (26). In dem Loch (26) ist zentrisch zur optischen Achse (OA) eine ringförmige Elektrode (23) mit einer zentralen Ringöffnung (24) angeordnet. Die ringförmige Elektrode (23) ist über zwei oder drei dünne Haltestege (22, 27) mit dem Träger (21) verbunden. Durch Beaufschlagung der ringförmigen Elektrode mit einem elektrostatischen Potenzial wird dem durch die Ringöffnung (24) durchtretenden Nullstrahl der in der Objektebene (9) ungebeugten Strahlen eine Phasenverschiebung aufgeprägt, während die in der Objektebene in höhere Ordnungen gebeugte oder gestreute Strahlung unbeeinflusst bleibt. Hinsichtlich weiterer Details zum Aufbau der Phasenplatte (16) sei auf die US 6,797,956 verwiesen.

Durch eine Änderung der Erregnung der zweiten Beugungslinse (15) lässt sich durch die durch diese Linse bewirkte Bilddrehung die Orientierung des Beugungsbilds relativ zur Phasenplatte (16) ändern. Dadurch lassen sich für die Bildentstehung wesentliche Beugungsreflexe (25), die auf die Haltestege (22, 27) fallen, auf einer durch den gestrichelt eingezeichneten Kreis angedeuteten Kreisbahn bewegen und dadurch in einen Bereich drehen, in dem sie ungestört von einem Haltesteg (22, 27) die Phasenplatte passieren können.

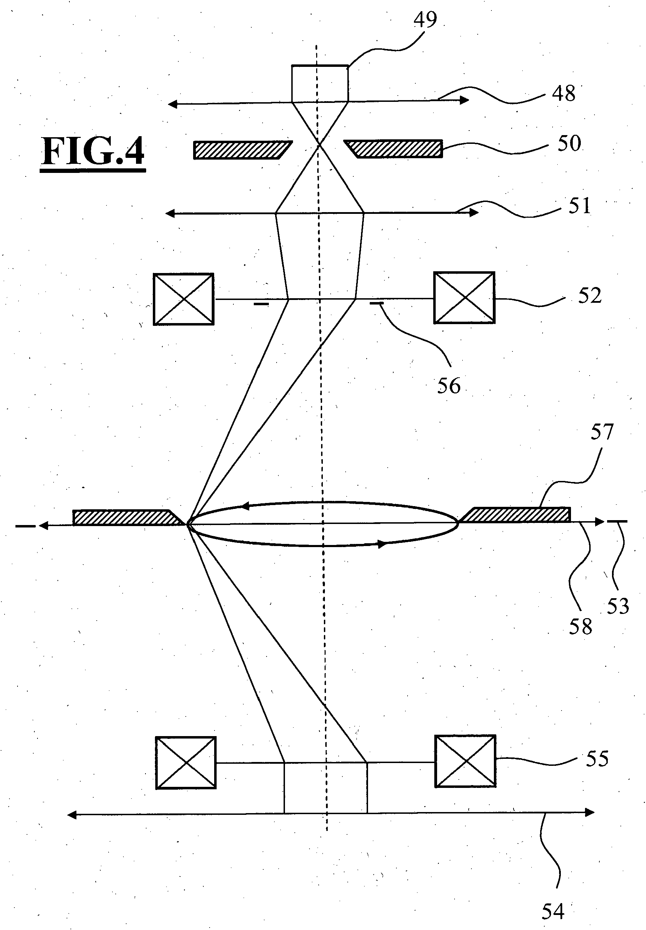

In der Figur 4 ist der Strahlverlauf im Fall der Erzeugung eines Phasenkontrasts mit einer konischen Beleuchtung nach der US 6,797,956 dargestellt. Der in der Objektebene (49) ungebeugte Nullstrahl wird in der hinteren Beugungsebene (50) des Objektivs (48) fokussiert und durch die erste Beugungslinse (51) in die Beugungszwischenbildebene (53) abgebildet. Das erste Ablenksystem (52) in der Nähe der Zwischenbildebene (56) führt das Strahlenbündel ringförmig über die phasenschiebenden Bereiche einer ringförmigen Phasenplatte (57) in der Beugungszwischenbildebene (53). Die zweite Beugungslinse (58), deren Hauptebene in oder in der Nähe der Beugungszwischenbildebene (53) liegt, erzeugt dann wieder ein Zwischenbild der Objektebene (49) in der Eingangsbildebene der ersten Projektivlinse (54). Durch ein in der Eingangsbildebene der ersten Projktivlinse (54) angeordnetes weiteres Ablenksystem (55), das synchron zum ersten Ablenksystem (52) betrieben wird, kann der Strahl in der Eingangsbildebene der ersten Projektivlinse (54) wieder auf die optische Achse zurück gelenkt werden.

Durch eine in der Beugungszwischenbildebene (53) angeordnete ringförmige Phasenplatte wird dem auf einer Kreisbahn geführten Nullstrahl eine Phasenverschiebung aufgeprägt, während die weiter beabstandet vom Rand der Mittenöffnung der Phasenplatte passierenden Elektronen, die in der Objektebene (49) in höhere Beugungsordnungen gebeugt wurden, von der Phasenplatte unbeeinflusst bleiben. Durch Interferenz dieser höheren Beugungsordnungen mit dem phasenverschobenen Nullstrahl entsteht dann wieder der Phasenkontrast.

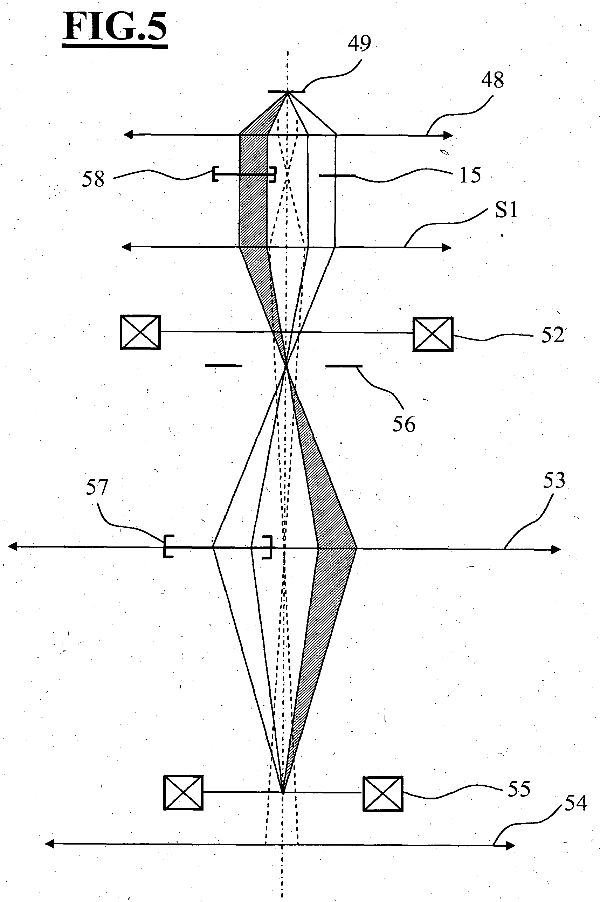

Die Anordnung in Figur 5 ist im Wesentlichen gleich wie die Anordnung in der Figur 4 aufgebaut. Allerdings weist die Anordnung in der Figur 5 zwei Phasenplatten auf. Die erste Phasenplatte (58) ist in der hinteren Beugungsebene (15) der Objektivlinse und eine zweite Phasenplatte (57) ist in der dazu konjugierten Bildebene der ersten Beugungslinse (51) angeordnet, die in oder in der Nähe der Hauptebene der zweiten Beugungslinse (53) liegt. Wie bei den zuvor beschriebenen Ausführungsformen bildet die zweite Beugungslinse das zwischen der ersten und zweiten Beugungslinse (51, 53) liegende einzige reelle Zwischenbild der Objektebene (49) in die Eingangsbildebene des Projektivsystems (54) ab.

Die beiden Phasenplatten (57, 58) sind so ausgebildet, dass sie jeweils unterschiedliche, zu einander komplementäre räumliche Bereiche der Beugungsbilder beeinflussen. Wie in der Figur 5 angedeutet, erzeugt die in der Beugungsebene (15) des Objektivs angeordnete Phasenplatte (58) in dem in der Figur 5 schraffiert dargestellten Strahlkegelsegment eine Phasenverschiebung, während die zweite, in der Beugungszwischenbildebene angeordnete zweite Phasenplatte (57) in dem nicht schraffierten Strahlkegelsegment eine Phasenverschiebung erzeugt. Die Phasenverschiebung erfolgt hier in den beiden zu einander konjugierten Beugungsbildern sequenziell, so dass sich aus beiden Beiträgen zusammen die gewünschte Phasenverschiebung zwischend dem Nullstrahl und den gebeugten Strahlen ergibt. Dieser Weg bietet prinzipiell die Möglichkeit, materiefreie und aberrationsfreie elektrostatische Phasenplatten zu realisieren. Außerdem können beide Phasenplatten (57, 58) jeweils so ausgebildet werden, dass eventuell vorhandene Haltestege insgesamt die Bilderzeugung nicht negativ beeinflussen. Erfahren nur die gestreuten Elektronen mit einer halbebenen Phasenplatte eine Phasenverschiebung von π, so lässt sich differenzieller Interferenzkontrast (Differenzial Interferenz Kontrast) erzeugen.

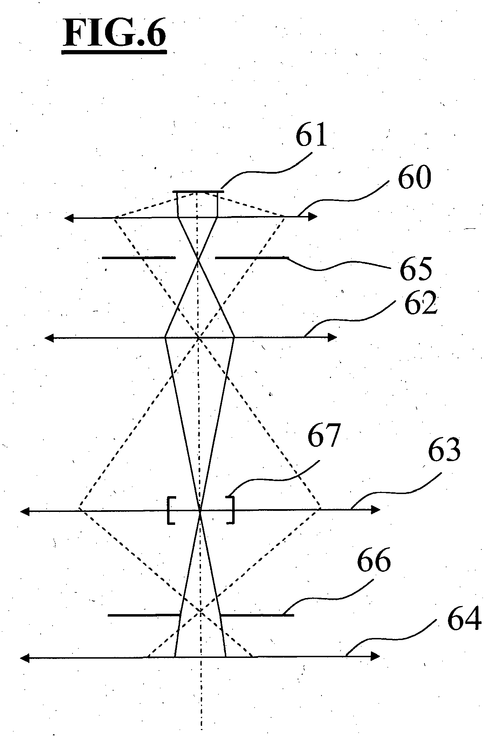

In der Figur 6 ist eine etwas andere Strahlführung mit der bereits anhand der Figuren 1 und 2 beschriebenen Ausführungsform dargestellt. Der wesentliche Unterschied ist, dass die Objektivlinse (60) so stark erregt ist, dass sie in oder in der Nähe der Hauptebene der ersten Beugungslinse (62) bereits ein Zwischenbild der Objektebene (61) erzeugt. Die erste Beugungslinse (62) bildet wiederum die hintere Beugungsebene (65) der Objektivlinse (60) in oder in die Nähe der Hauptebene der zweiten Beugungslinse (63) ab, so dass dort wieder eine Beugungszwischenbildebene entsteht. In der Beugungszwischenbildebene ist dann wieder das phasenschiebende Element (67) angeordnet. Wie bei der Ausführungsform in Figur 2 bildet die zweite Beugungslinse (63) das nun in der Hauptebene oder in der Nähe der Hauptebene der ersten Beugungslinse entstehende Zwischenbild der Objektebene (61) in die Eingangsbildebene (66) des nachfolgenden Projektivsystems (64) ab.

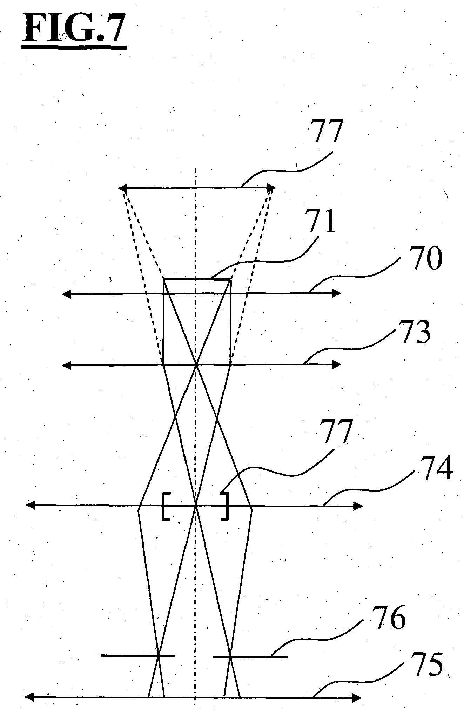

In der Figur 7 ist der beim Betrieb des Systems als Lorenzmikroskop oder bei geringer Vergrößerung realisierte Strahlengang dargestellt. Beim Betrieb als Lorenzmikroskop ist die Objektivlinse (70) abgestellt, bei geringer Vergrößerung (so genannter Low-Mag-Mode) ist die Objektivlinse nur ganz schwach erregt. Die Erregung der ersten Beugungslinse (73) ist so gewählt, dass ihre Brennebene in der Hauptebene der zweiten Beugungslinse (74) liegt. In der Hauptebene der zweiten Beugungslinse ist wiederum die Phasenplatte (77) angeordnet. Die zweite Beugungslinse (74) erzeugt in der Eingangsbildebene (76) des nachfolgenden Projektivsystems (75) ein reelles Bild des von der ersten Beugungslinse (73) erzeugten virtuellen Bilds (77) der Objektebene (71). Das Projektiv (75) erzeugt dann ein bis zu einem Faktor 10.000 vergrößertes Bild des in der Objektebene (71) positionierten Objekts. Diese Strahlführung ermöglicht damit eine etwa um den Faktor 5 größere Maximalvergrößerung gegenüber einer konventioellen Low-Mag Vergrößerung.

Hinsichtlich der erforderlichen Dimensionen bei der Strahlführung gemäß Figur 2 lässt sich etwa folgendes abschätzen: Bei einer Brennweite der Objektivlinse (8) von etwa 3 mm und einer gewünschten Teleskopvergrößerung um den Faktor 10 (da die Objektivlinse (8) und die erste Beugungslinse (11) ja teleskopisch betrieben werden) resultiert für die erste Beugungslinse (11) eine Brennweite von etwa 30 mm. Es lässt sich zeigen, dass bei einem derartigen Teleskopsystem die Zunahme des Öffnungsfehlers gegenüber einem System nur mit der Objektivlinse vernachlässigbar ist.

Soll die Beugungszwischenbildebene etwa um den Faktor 5 gegenüber der hinteren Beugungsebene (10) der Objektivlinse (8) vergrößert sein, so muss die erste Beugungslinse (11) einen Abstand von etwa 36 mm von der hinteren Beugungsebene (10) der Objektivlinse (8) haben und zwischen der ersten Beugungslinse (11) und der zweiten Beugungslinse (15) ist ein Abstand von 180 mm erforderlich. Da die zweite Beugungslinse (15) das in der hinteren Brennebene (14) der ersten Beugungslinse (11) entstehende Zwischenbild der Objektebene (9) mit schwacher Vergrößerung in die Eingangsbildebene (17) des Projektivsystems (18) abbildet, resultiert bei einer Brennweite der zweiten Beugungslinse (15) von etwa 75 mm ein erforderlicher Abstand von etwa 150 mm zwischen der zweiten Beugungslinse (15) und der Eingangsbildebene (17) des Projektivsystems (18). Insgesamt ergibt sich dann eine gesamte Baulängenvergrößerung von etwa 260 mm gegenüber einer Anordnung, bei der die Objektivlinse (8) direkt ein reelles Zwischenbild in der Eingangsbildebene des Projektivsytems erzeugt.

## Patentansprüche

1. Phasenkontrast-Elektronenmikroskop mit einem Objektiv (8) mit einer hinteren Brennebene (10), einer ersten Beugungslinse (11), die die hintere Brennebene (10) des Objektivs (8) in eine Beugungs-Zwischenbildebene (21) abbildet, einem phasenschiebenden Element (16), das in der Beugungs-Zwischenbildebene (21) angeordnet ist und einer zweiten Beugungslinse (15), **dadurch gekennzeichnet, dass** die Abbildung der hinteren Brennebene (10) des Objektivs (8) in die Beugungs-Zwischenbildebene vergrößernd erfolgt und dass die Hauptebene der zweiten Beugungslinse (15) in der Beugungs-Zwischenbildebene (21) angeordnet ist.

2. Phasenkontrast-Elektronenmikroskop nach Anspruch 1, **dadurch gekennzeichnet, dass** ein erstes phasenschiebendes Element (53) in der hinteren Brennebene (10) des Objektivs angeordnet ist, und dass ein zweites phasenschiebendes Element (57) in der Beugungs-Zwischenbildebene (21) angeordnet ist.

3. Phasenkontrast-Elektronenmikroskop nach Anspruch 1 oder 2, wobei das Objektiv (8) oder das Objektiv (8) gemeinsam mit der ersten Beugungslinse (11) eine Eingangsbildebene des Objektivs (8) in eine Zwischenbildebene (14) abbildet, wobei die Zwischenbildebene (14), in Strahlrichtung betrachtet, vor der Beugungsbild-Zwischenbildebene (21) liegt, und wobei im Bereich der Zwischenbildebene (14) ein Strahlablenksystem (12, 13) angeordnet ist.

4. Phasenkontrast-Elektronenmikroskop nach Anspruch 3, wobei das Strahlablenksystem (12, 13) ein Doppelablenksystem ist, das einen Elektronenstrahl in zwei zueinander senkrechten Richtungen ablenkt.

5. Phasenkontrast-Elektronenmikroskop nach Anspruch 4, wobei das Strahlablenksystem (12) in einer ersten Richtung eine sinusförmige Strahlablenkung und in der zur ersten Richtung senkrechten Richtung eine cosinusförmige Strahlablenkung bewirkt, so dass der Elektronenstrahl in einer Beugungsebene (21) insgesamt auf einer kreisförmigen Bahn bewegt wird.

6. Phasenkontrast-Elektronenmikroskop nach einem der Ansprüche 1 bis 5, wobei zusätzlich eine Elektronenquelle (1) und ein Kondensorsystem (5, 6, 7) vorgesehen sind, wobei das Kondensorsystem (5, 6, 7) Elektronenlinsen aufweist, die aus den aus der Elektronenquelle (1) austretenden Elektronen einen Elektronenstrahl formen.

7. Phasenkontrast-Elektronenmikroskop nach Anspruche 6, wobei das Kondensorsystem (5, 6, 7) eine Gegenstandsebene (9) des Objektivs (8) ausleuchtet.

8. Phasenkontrast-Elektronenmikroskop nach einem der Ansprüche 3 bis 5 oder, soweit auf einen der Ansprüche 3 bis 5 zurückbezogen, nach einem der Ansprüche 6 oder 7, wobei die zweite Beugungslinse (15) die Zwischenbildebene (14) in eine zweite Zwischenbildebene (17) abbildet und nachfolgend ein Projektivsystem (18, 19) vorgesehen ist, das die zweite Zwischenbildebene (17) vergrößert in eine Endbildebene abbildet.

9. Phasenkontrast-Elektronenmikroskop nach einem der Ansprüche 1 bis 8, wobei das Elektronenmikroskop als Lorenzmikroskop mit nicht oder nur schwach erregter Objektivlinse (8) betreibbar ist.

## Claims

1. Phase-contrast electron microscope comprising an objective (8) with a rear focal plane (10), a first diffraction lens (11), which images the rear focal plane (10) of the objective (8) in a diffraction intermediate image plane (21), a phase-shifting element (16), which is arranged in the diffraction intermediate image plane (21), and a second diffraction lens (15), **characterized in that** the imaging of the rear focal plane (10) of the objective (8) into the diffraction intermediate image plane is carried out in a magnifying manner and **in that** the principal plane of the second diffraction lens (15) is arranged in the diffraction intermediate image plane (21).

2. Phase-contrast electron microscope according to Claim 1, **characterized in that** a first phase-shifting element (53) is arranged in the rear focal plane (10) of the objective and **in that** a second phase-shifting element (57) is arranged in the diffraction intermediate image plane (21).

3. Phase-contrast electron microscope according to Claim 1 or 2, wherein the objective (8) or the objective (8) together with the first diffraction lens (11) images an input image plane of the objective (8) into an intermediate image plane (14), wherein the intermediate image plane (14), when considered in the beam direction, lies upstream of the diffraction image intermediate image plane (21) and wherein a beam deflection system (12, 13) is arranged in the region of the intermediate image plane (14).

4. Phase-contrast electron microscope according to Claim 3, wherein the beam deflection system (12, 13) is a double deflection system, which deflects an electron beam in two mutually perpendicular directions.

5. Phase-contrast electron microscope according to Claim 4, wherein the beam deflection system (12) brings about a sinusoidal beam deflection in a first direction and a cosinusoidal beam deflection in the direction perpendicular to the first direction such that, overall, the electron beam is moved on a circular trajectory in a diffraction plane (21).

6. Phase-contrast electron microscope according to one of Claims 1 to 5, wherein provision is additionally made of an electron source (1) and a condenser system (5, 6, 7), wherein the condenser system (5, 6, 7) has electron lenses which form an electron beam from the electrons emerging from the electron source (1).

7. Phase-contrast electron microscope according to Claim 6, wherein the condenser system (5, 6, 7) illuminates an object plane (9) of the objective (8).

8. Phase-contrast electron microscope according to one of Claims 3 to 5 or according to one of Claims 6 and 7, provided that these refer back to one of Claims 3 to 5, wherein the second diffraction lens (15) images the intermediate image plane (14) into a second intermediate image plane (17) and subsequently provision is made of a projective system (18, 19) which images the second intermediate image plane (17) into a final image plane in a magnified manner.

9. Phase-contrast electron microscope according to one of Claims 1 to 8, wherein the electron microscope is operable as a Lorenz microscope with an objective lens (8) that is not or only weakly excited.

## Revendications

1. Microscope électronique à contraste de phase présentant
un objectif (8) doté d'un plan focal arrière (10), une première lentille de diffraction (11) qui forme le plan focal arrière (10) de l'objectif (8) dans un plan (21) d'image intermédiaire de diffraction,
un élément de déphasage (16) disposé dans le plan (21) d'image intermédiaire de diffraction et
une deuxième lentille de diffraction (15), **caractérisé en ce que**
la formation du plan focal arrière (10) de l'objectif (8) dans le plan d'image intermédiaire de diffraction s'effectue avec agrandissement et
**en ce que** le plan principal de la deuxième lentille de diffraction (15) est disposé dans le plan (21) d'image intermédiaire de diffraction.

2. Microscope électronique à contraste de phase selon la revendication 1, **caractérisé en ce qu'**un premier élément de déphasage (53) est disposé dans le plan focal arrière (10) de l'objectif et **en ce qu'**un deuxième élément de déphasage (57) est disposé dans le plan (21) d'image intermédiaire de diffraction.

3. Microscope électronique à contraste de phase selon les revendications 1 ou 2, dans lequel l'objectif (8) ou l'objectif (8) et la première lentille de diffraction (11) forment le plan d'image d'entrée de l'objectif (8) dans un plan (14) d'image intermédiaire, le plan (14) d'image intermédiaire étant disposé en avant du plan (21) d'image intermédiaire de diffraction vu dans la direction du faisceau, un système (12, 13) de diffraction du faisceau étant disposé au niveau du plan (14) d'image intermédiaire.

4. Microscope électronique à contraste de phase selon la revendication 3, dans lequel le système de diffraction de faisceau (12, 13) est un système à déviation double qui dévie un faisceau d'électrons dans deux directions mutuellement perpendiculaires.

5. Microscope électronique à contraste de phase selon la revendication 4, dans lequel le système (12) de diffraction de faisceau a pour effet dans une première direction une déviation sinusoïdale du faisceau et dans la direction perpendiculaire à la première direction une déviation cosinusoïdale du faisceau de telle sorte que le faisceau d'électrons soit déplacé globalement sur une piste circulaire dans un plan de diffraction (21).

6. Microscope électronique à contraste de phase selon l'une des revendications 1 à 5, dans lequel une source (1) d'électrons et un système (5, 6, 7) de condenseur sont de plus prévus, le système (5, 6, 7) de condenseur présentant des lentilles à électrons qui forment un faisceau d'électrons à partir des électrons qui sortent de la source (1) d'électrons.

7. Microscope électronique à contraste de phase selon la revendication 6, dans lequel le système de condenseur (5, 6, 7) éclaire un plan d'objet (9) de l'objectif (8).

8. Microscope électronique à contraste de phase selon l'une des revendications 3 à 5 ou, dans la mesure où il est conforme à l'une des revendications 3 à 5, selon l'une des revendications 6 ou 7, dans lequel la deuxième lentille de diffraction (15) forme le plan (14) d'image intermédiaire dans un deuxième plan (17) d'image intermédiaire et dans lequel un système de projection (18, 19) est prévu à la suite pour former le deuxième plan (17) d'image intermédiaire agrandi dans un plan d'image final.

9. Microscope électronique à contraste de phase selon l'une des revendications 1 à 8, dans lequel le microscope électronique peut être utilisé comme microscope de Lorenz avec une lentille d'objectif (8) non excitée ou faiblement excitée.
